Europäisches Patentamt

European Patent Office

Office européen des brevets

(19)

(11) **EP 1 523 033 A1**

(12) **EUROPEAN PATENT APPLICATION**
published in accordance with Art. 158(3) EPC

(43) Date of publication:
**13.04.2005 Bulletin 2005/15**

(51) Int Cl.[7]: **H01L 21/205**

(21) Application number: **04734604.4**

(86) International application number:
**PCT/JP2004/007420**

(22) Date of filing: **24.05.2004**

(87) International publication number:
**WO 2004/112112 (23.12.2004 Gazette 2004/52)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **10.06.2003 JP 2003165083**

(71) Applicant: **SUMITOMO ELECTRIC INDUSTRIES, Ltd**
**Osaka-shi, Osaka 541-0041 (JP)**

(72) Inventor: **NAKAHATA, Seiji;**
**c/o Itami Works of Sumitomo Elect Hyogo;6640016 (JP)**

(74) Representative: **Grünecker, Kinkeldey, Stockmair & Schwanhäusser Anwaltssozietät**
**Maximilianstrasse 58**
**80538 München (DE)**

(54) **GROUP III NITRIDE CRYSTAL AND METHOD FOR PRODUCING SAME**

(57)     A group III nitride crystal having a small dislocation density and good quality and a production method for the group III nitride crystal are provided. The production method for the group III nitride crystal is **characterized by** growing a group III nitride crystal film 2 on a substrate 1, depositing a metallic film 3 thereon and, then, not only changing the metallic film 3 into a metallic nitride film 4 and, further, generating a pore 4h, but also forming a void portion 2b in the group III nitride crystal film 2 by performing a thermal treatment and, thereafter, filling the void portion 2b by a group III nitride crystal 5 for filling by further growing a group III nitride crystal and, subsequently, growing a group III nitride crystal 6 on the metallic nitride film 4.

FIG. 1A

EP 1 523 033 A1

**Description**

Technical Field

The present invention relates to a group III nitride crystal and a production method for the group III nitride crystal and, particularly, to a group III nitride having a low dislocation density and good quality, and a production method for the group III nitride crystal.

Background Art

A group III nitride crystal such as $Al_xGa_yIn_{1-x-y}N$ crystal ($0 \leq x$, $0 \leq y$, $x+y \leq 1$) appears in the limelight as a material for a Light Emitting Diode (hereinafter, referred to as "LED") or a Laser Diode (hereinafter, referred to as "LD") and is expected to be deployed as an electronic device element.

However, it is difficult to grow the group III nitride crystal in bulk crystal growth and, accordingly, a self-supporting substrate of the group III nitride crystal has not been obtained. A substrate of the group III nitride crystal which is presently in practical use is a sapphire substrate and a method in which the group III nitride crystal is epitaxially grown on a single crystal sapphire substrate by, for example, a Metalorganic Vapor Phase Epitaxy (hereinafter, referred to as "MOVPE") method has ordinarily been employed.

Meanwhile, since the sapphire substrate is different in a lattice constant from the $Al_xGa_yIn_{1-x-y}N$ crystal, even when the $Al_xGa_yIn_{1-x-y}N$ crystal is grown directly on the sapphire substrate, a single crystal can not be obtained.

Thus, a method in which, firstly, a buffer layer of the $Al_xGa_yIn_{1-x-y}N$ crystal is grown on the sapphire substrate at a low temperature and, then, the $Al_xGa_yIn_{1-x-y}N$ crystal is then grown on the buffer layer has been proposed (refer to, for example, JP-A No. 63-188983). By providing such buffer layer, a strain between a lattice of the substrate and that of the $Al_xGa_yIn_{1-x-y}N$ crystal was relaxed, to thereby realize an epitaxial growth of the $Al_xGa_yIn_{1-x-y}N$ single crystal. However, even in such method, by a strain between the substrate and the lattice of the $Al_xGa_yIn_{1-x-y}N$ crystal, a dislocation of from $10^9$ to $10^{10}$ cm$^{-2}$ is generated, to thereby cause a problem in preparing the LD or the like.

In order to reduce a dislocation density, a method in which a GaN layer is grown on the sapphire substrate and, thereafter, a metallic layer is deposited on the thus-grown GaN layer and, subsequently, the resultant article is thermally treated to form a void portion in the GaN layer which is then filled by performing the GaN crystal growth and, thereafter, the GaN crystal is grown on the metallic layer has been proposed (refer to, for example, JP-A No. 2002-343728).

Disclosure of the Invention

At present growth of group III nitride crystals other than a GaN crystal has not been conducted by the aforementioned method.

Under these circumstances, an object of the present invention is to provide not only the GaN crystal but also a group III nitride crystal having a small dislocation density and good quality and a production method for these crystals.

In order to attain the aforementioned object, a production method for a group III nitride crystal according to the present invention is characterized by comprising the steps of:

growing a group III nitride crystal film on a substrate;
depositing a metallic film on the group III nitride crystal film;
not only generating a pore in the metallic film, but also forming a void portion in the group III nitride crystal film by thermally treating the substrate on which the group III nitride crystal film is grown and the metallic film is deposited;
growing a group III nitride crystal for filling on the group III nitride crystal film in which the void portion is formed in an atmosphere of an oxygen concentration of 0.1% by mol or less to fill the void portion in the group III nitride crystal film; and
growing a group III nitride crystal on the metallic film in an atmosphere of an oxygen concentration of 0.1% by mol or less.

Further, a production method for a group III nitride crystal according to the present invention is characterized by comprising the steps of:

growing a group III nitride crystal film on a substrate;
depositing a metallic film on the group III nitride crystal film;
not only changing the metallic film into a metallic nitride film, and further, generating a pore in the metallic film, but also forming a void portion in the group III nitride crystal film by thermally treating the substrate on which the group III nitride crystal film is grown and the metallic film is deposited;

growing a group III nitride crystal for filling on the group III nitride crystal film in which the void portion is formed in an atmosphere of an oxygen concentration of 0.1% by mol or less to fill the void portion in the group III nitride crystal film; and

growing a group III nitride crystal on the metallic nitride film in an atmosphere of an oxygen concentration of 0.1% by mol or less.

Further, a group III nitride crystal according to the present invention is obtained by the aforementioned method for obtaining the group III nitride crystal.

Brief Description of Drawings

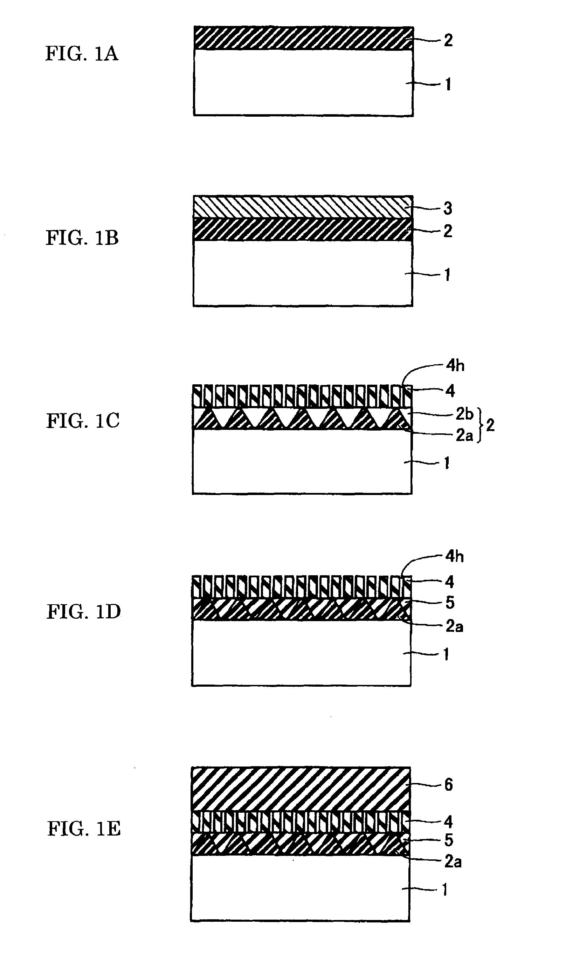

Figure 1 is a diagram explaining a production method for a group III nitride crystal according to the present invention.

Best Mode for Carrying Out the Invention

One production method for a group III nitride crystal according to the present invention, in reference to Fig. 1, comprises the step of growing a group III nitride crystal film 2 on a substrate 1 as shown in Fig. 1A, the step of depositing a metallic film 3 on the group III nitride crystal film 2 as shown in Fig. 1B, the step of obtaining a group III nitride crystal portion 2a in which, not only a pore 4h is generated in the metallic layer, but also a void portion 2b is formed in the group III nitride crystal film 2 by thermally treating the substrate on which the group III nitride crystal film is grown and the metallic film is deposited as shown in Fig. 1C, the step of filling the void portion in the group III nitride crystal film 2 by growing a group III nitride crystal 5 for filling (the group III nitride crystal grown for the purpose of filling the void portion in the group III nitride crystal film) on the group III nitride crystal portion 2a in which the void portion 2b is formed in an atmosphere of an oxygen concentration of 0.1% by mol or less as shown in Fig. 1D, and the step of growing a group III nitride crystal 6 on the metallic film in an atmosphere of an oxygen concentration of 0.1% by mol or less as shown in Fig. 1E.

By growing the group III nitride crystal 5 for filling in the void portion 2b in the group III nitride crystal film 2 generated by performing a thermal treatment after the group III nitride crystal film 2 and the metallic film 3 are formed to fill the void portion 2b and, further, growing the group III nitride crystal 6 on the metallic film in which the pore 4h is generated by the thermal treatment, a strain caused by a difference in a lattice constant between the substrate 1 and the group III nitride crystal 6 can be eliminated. Therefore, the thermal treatment is satisfactory provided that it is performed at a temperature necessary for forming the void portion in the group III nitride film. Under these circumstances, it is preferable that the temperature of the thermal treatment be 700°C or more.

Further, by defining the atmosphere at the time of growing the group III nitride crystal 5 for filling in the void portion 2b and growing the group III nitride crystal 6 on the metallic film in which the pore 4h is generated as an oxygen concentration of 0.1% by mol or less, a wide range of group III nitride crystals including not only a GaN crystal, but also an $Al_xGa_yIn_{1-x-y}N$ crystal can favorably be grown. When the oxygen concentration is over 0.1% by mol, a dislocation density becomes large and an oxide may be generated or a spot defect to be caused by mixing of an oxygen ion may be generated thus inhibiting a favorable growth of the group III nitride crystal. From the standpoint of allowing the dislocation density to be small, the oxygen concentration is more preferably 0.01% by mol or less.

Another production method for the group III nitride crystal according to the present invention, in reference to Fig. 1, comprises the step of growing the group III nitride crystal film 2 on the substrate 1 as shown in Fig. 1A, the step of depositing the metallic film 3 on the group III nitride crystal film 2 as shown in Fig. 1B, the step of not only changing the metallic film 3 into a metallic nitride film 4 and generating the pore 4h in the metallic nitride film 4, but also forming the void portion 2b in the group III nitride crystal film 2 by thermally treating the substrate on which the group III nitride crystal film 2 is grown and the metallic film is deposited as shown in Fig. 1C, the step of filling the void portion in the group III nitride crystal film 2 by growing the group III nitride crystal 5 for filling on the group III nitride crystal film 2 in which the void portion 2b is formed in an atmosphere of an oxygen concentration of 0.1% by mol or less as shown in Fig. 1D, and the step of growing the group III nitride crystal 6 on the metallic nitride film 4 in an atmosphere of an oxygen concentration of 0.1% by mol or less as shown in Fig. 1E.

By performing a thermal treatment after the group III nitride crystal film 2 and the metallic film 3 are formed, at least a surface of the metallic film 3 is ordinarily nitrided to form the metallic nitride film 4 and, in order to promote nitriding of the metallic film, it is preferable that an $N_2$ gas or a gas containing a nitrogen atom (for example, $NH_3$ gas) be added as a nitrogen source at the time of the thermal treatment. In such a manner of generating the metallic nitride, forming of the pore 4h is promoted to facilitate the growth of the group III nitride crystal 5 for filling in the void portion 2b.

On the other hand, by performing the thermal treatment, even when the surface of the metallic film 3 is not nitrided, provided that at least the pore 4h is formed in the metallic film 3 and, further, the void portion 2b is formed in the group III nitride crystal film 2, at the time of forming the group III nitride crystal in an atmosphere of an oxygen concentration of 0.1% by mol or less, the group III nitride crystal is preferentially grown in the void portion 2b through the pore generated in the metallic film as the group III nitride crystal 5 for filling, to thereby fill the void portion 2b; therefore, the strain caused by the difference in the lattice constant between the substrate 1 and the group III nitride crystal 6 can be eliminated. On this occasion, according to the present invention, a reducing atmosphere of an oxygen concentration of 0.1% by mol or less is formed as an atmosphere at the time of growing the group III nitride crystal for filling and the group III nitride crystal. The method of forming the atmosphere of an oxygen concentration of 0.1% by mol or less is not particularly limited provided that it does not go counter to the object of the present invention. For example, a method in which, in addition to the $N_2$ gas or the $NH_3$ gas being used as a nitrogen source, and the $H_2$ gas being used as an oxygen reducing agent, a method using carbon or the like is mentioned as a favorable method. It is also favorable to use these methods simultaneously. On this occasion, when the $H_2$ gas which is an oxygen reducing gas and the $NH_3$ gas which is a nitrogen raw material gas are concurrently present, it is considered that oxygen is removed by a reaction represented by the formula (1) to be described below. In such case as described above, a molar ratio of the $H_2$ gas to the $NH_3$ gas is preferably 10% or more. When the molar ratio is less than 10%, it is considered that an oxygen reduction effect is reduced.

$$3H_2+2NH_3+O_2 \rightarrow 2NH_4+2H_2O \tag{1}.$$

As for carbon (C), activated carbon, a carbon plate made of carbon, or the like is favorably used. When carbon is used, it is preferable to use carbon having a surface area (hereinafter, referred to also as "unit surface area"), based on 1 $m^3$ of an entire raw material gas, of 100 $cm^2/m^3$ or more.

In the production method for the group III nitride crystal according to the present invention, as for group iII nitride crystals, an $Al_xGa_yIn_{1-x-y}N$ crystal is preferable. In the group III nitride crystal, the $Al_xGa_yIn_{1-x-y}N$ crystal is extremely useful as a material for an LED or LD.

In the production method for the group III nitride crystal according to the present invention, as for metallic films, titanium, vanadium or an alloy comprising at least one of titanium and vanadium is favorably mentioned. Metals or alloys other than these metals or the alloy can be used provided that they have a catalytic action of promoting decomposition of the group III nitride crystal film. For example, Fe, Ni, Zr, Hf, W, Pt or an alloy comprising at least one metal element of these metals can be mentioned.

Further, the thickness of the metallic film is preferably from 10 nm to 1000 nm. In a case in which the thickness is less than 10 nm, when nitriding is performed, even when it is over 1000 nm the metallic film is liable to be peeled off, and it is difficult to generate the pore. Still further, in view of generating a stable pore, the thickness of the metallic film is more preferably from 20 nm to 500 nm.

Further, in the production method for the group III nitride crystal according to the present invention, only the group III nitride crystal grown on the metallic film on the substrate can be obtained by removing the substrate. A method of removing the substrate is not particularly limited, and a method of removing the substrate by grinding or laser irradiation while the substrate is held, a method of separating the substrate having a different thermal expansion coefficient from the group III nitride crystal film by heat shock or the like can favorably be used.

Further, still another production method for the group III nitride crystal according to the present invention comprises the step of further growing a group III nitride crystal on the group III nitride crystal obtained by the aforementioned production method for the group III nitride crystal in an atmosphere of an oxygen concentration of 0.1% by mol or less. The production method for the group III nitride crystal according to the present invention can be applied to multiple-stage growth of the group III nitride crystal, and allows the thickness of a layer of the group III nitride crystal having a small dislocation density to be large or allows the layers of two types or more of the group III nitride crystals each having a small dislocation density to be formed.

The group III nitride crystal according to the present invention can be obtained by the aforementioned production method. By the production method, not only can the strain caused by the difference in the lattice constant between the substrate and the group III nitride crystal be eliminated, but also the oxygen concentration at the time of growing the group III nitride crystal be maintained at such a low concentration as 0.1% by mol or less and, accordingly the group III nitride crystal having a small dislocation density and good quality can be obtained.

Examples

Hereinafter, the present invention will more specifically be described with reference to the embodiments.

Example 1

In reference to Fig. 1, as shown in Fig. 1A, a 200 nm AIN crystal film which is a group III nitride crystal film 2 was grown on a sapphire substrate which is a substrate 1 by using an MOCVD method. On this occasion, trimethyl aluminum and $NH_3$ were used as a group III raw material and a nitrogen raw material, respectively. Next, as shown in Fig. 1B, 100 nm of a Ti film was deposited as a metallic film 3 on the AIN crystal film which is a group III nitride crystal film 2 by an evaporation method. Subsequently, as shown in Fig. 1C, the resultant article was thermally treated for 30 minutes at 1000°C in an atmosphere of $NH_3$ gas in an oven (in Example 1, HVPE oven) for growing the crystal of the group III nitride crystal. By such thermal treatment as described above, a pore 4h was formed in the metallic film 3 while a void portion 2b was formed in the AIN crystal film which is the group III nitride crystal film 2. When the surface of the metallic film was analyzed by X-ray Diffraction (hereinafter, referred to also as "XRD"), it was found that the TiN film was formed.

Thereafter, as shown in Figs. 1D and 1E, an AIN crystal which is each of a group III nitride crystal 5 for filling and a group III nitride crystal 6 was grown by using Al and $NH_3$ as a group III raw material and a nitrogen raw material, respectively, by using a Hydride Vapor Phase Epitaxy (hereinafter, referred to also as "HVPE") method. On this occasion, an HCl gas was used as a carrier gas for Al; 40% of an $H_2$ gas based on the $NH_3$ gas which is a nitrogen raw material gas was used as an oxygen reducing agent; and a plate made of carbon having a unit surface area of 200 $cm^2/m^3$ was used. Growth of the AIN crystal by the HVPE method first appeared preferentially in the void portion 2b of the AIN crystal film passing through the pore 4h in the metallic film, to thereby fill the void portion 2b. Thereafter, 400 $\mu$m of an AIN crystal which is the group III nitride crystal 6 was grown on a Ti film on a surface of which the TiN film which is the metallic nitride film 4 was formed. The resultant AIN crystal showed a Full Width Half Maximum (hereinafter, referred to also as "FWHM") value of 90 arsec by XRD and a dislocation density of 6x10$^7$ cm$^{-2}$ by TEM observation. The results are collectively shown in Table I.

Examples 2 to 6

A group III nitride crystal was prepared in the same manner as in Example 1 under the conditions shown in Table I or II, and then, was subjected to measurements of an FWHM value by XRD and a dislocation density. The results are collectively shown in Table I or II.

Table I

| | | | | Example 1 | Example 2 | Example 3 |
|---|---|---|---|---|---|---|
| Substrate | | | | Sapphire | Sapphire | Sapphire |
| Group III nitride crystal film | Growth condition | Growth method | | MOCVD | MOCVD | MOCVD |
| | | Group III raw material (mol%) | | TM-Al | TM-In | TM-Ga (90) TM-In (10) |
| | | Nitrogen raw material | | $NH_3$ | $NH_3$ | $NH_3$ |
| | Film | Crystal composition | | AlN | InN | $Ga_{0.9}In_{0.1}N$ |
| | | Film thickness (nm) | | 200 | 50 | 50 |
| Metallic film | Deposition condition | Deposition method | | Evaporation | Evaporation | Evaporation |
| | | Raw material | | Ti | Ti | Ti-Al |
| | Generated film | Film composition | | Ti | Ti | Ti-Al |
| | | Film thickness (nm) | | 100 | 30 | 300 |
| Thermal treatment | | Processing gas | | $NH_3$ | $NH_3$ | $NH_3$ (80) $N_2$ (20) |
| Metallic film after subjected to thermal treatment | | Film composition | | TiN | TiN | $Ti_{0.5}Al_{0.5}N$ |
| | | Void ratio (%) | | 33 | 12 | 18 |
| Group III nitride crystal | Growth condition | Growth method | | HVPE | MOCVD | MOCVD |
| | | Group III raw material (mol%) | | Al | TM-In | TM-Ga (90) TM-In (10) |
| | | Nitrogen raw material | | $NH_3$ | $NH_3$ | $NH_3$ |
| | | Reducing agent | $H_2$ gas (mol%) | 40 | 10 | 10 |
| | | | Unit surface area of carbon ($cm^2/m^3$) | 200 | - | 200 |
| | | Oxygen concentration (mol%) | | 0.003 | 0.03 | 0.06 |
| | Crystal property | Crystal composition | | AlN | InN | $Ga_{0.9}In_{0.1}N$ |
| | | Thickness ($\mu m$) | | 400 | 5 | 10 |
| | | FWHM (arsec) | | 90 | 180 | 160 |
| | | Dislocation density ($cm^{-2}$) | | $6 \times 10^7$ | $8 \times 10^8$ | $3 \times 10^8$ |

Table II

| | | | Example 4 | Example 5 | Example 6 |
|---|---|---|---|---|---|
| Substrate | | | SiC | GaAs | Sapphire |
| Group III nitride crystal film | Growth condition | Growth method | MOCVD | MOCVD | MOCVD |
| | | Group III raw material (mol%) | TM-Al (40) TM-Ga (60) | TM-Ga | TM-Al (15) TM-Ga (80) TM-In (5) |
| | | Nitrogen raw material | $NH_3$ | $NH_3$ | $NH_3$ |
| | Film | Crystal composition | $Al_{0.4}Ga_{0.6}N$ | GaN | $Al_{0.15}Ga_{0.8}In_{0.05}N$ |
| | | Film thickness (nm) | 200 | 500 | 300 |
| Metallic film | Deposition condition | Deposition method | Evaporation | Evaporation | Evaporation |
| | | Raw material | V | V-Fe | Ti |
| | Generated film | Film composition | V | V | Ti |
| | | Film thickness (nm) | 800 | 300 | 500 |
| Thermal treatment | | Processing gas | $N_2$ | $NH_3$ | $NH_3$ |
| Metallic film after subjected to thermal treatment | | Film composition | VN | VN | TiN |
| | | Void ratio (%) | 36 | 21 | 34 |
| Group III nitride crystal | Growth condition | Growth method | HVPE | HVPE | MOCVD |
| | | Group III raw material (mol%) | Al (40) Ga (60) | Ga | TM-Al (15) TM-Ga (80) TM-In (5) |
| | | Nitrogen raw material | $NH_3$ | $NH_3$ | $NH_3$ |
| | | Reducing agent — $H_2$ gas (mol%) | 30 | 50 | 40 |
| | | Reducing agent — Unit surface area of carbon ($cm^2/m^3$) | - | 1000 | - |
| | | Oxygen concentration (mol%) | 0.02 | 0.006 | 0.01 |
| | Crystal property | Crystal composition | $Al_{0.4}Ga_{0.6}N$ | GaN | $Al_{0.15}Ga_{0.8}In_{0.05}N$ |
| | | Thickness ($\mu m$) | 250 | 300 | 10 |
| | | FWHM (arsec) | 120 | 70 | 130 |
| | | Dislocation density ($cm^{-2}$) | $5 \times 10^7$ | $6 \times 10^5$ | $9 \times 10^7$ |

Comparative Example 1

Firstly, 10 nm of a buffer layer of AIN was grown at an ambient temperature of 500°C and, subsequently, 100 μm of an AIN crystal was grown at an ambient temperature of 1000°C on a sapphire substrate by using an HVPE method. On this occasion, Al and $NH_3$ were used as a group III raw material and a nitrogen raw material, respectively. Further, 50% of an $H_2$ gas based on a $NH_3$ gas which is a nitrogen raw material gas was used as an oxygen reducing agent and a plate made of carbon having a unit surface area of 1000 $cm^2/m^3$ was used. The resultant AIN crystal showed an FWHM value of 220 arsec by XRD and a dislocation density of $8 \times 10^9$ $cm^{-2}$ by TEM observation.

Comparative Example 2

After an Al crystal film and a Ti film were formed on a sapphire substrate in the same manner as in Example 1, the resultant article was thermally treated. Thereafter, an AIN crystal was grown thereon by using an HVPE method. On this occasion, Al, an $NH_3$ gas and an HCl gas were used as a group III raw material, a nitrogen raw material and a carrier gas for Al, respectively. However, an oxygen reducing agent such as an $H_2$ gas or carbon was not used and the oxygen concentration was 0.5%. On this occasion, the AIN crystal was not obtained.

Example 7

500 µm of a $Al_{0.4}Ga_{0.6}N$ crystal was further grown on the $Al_{0.4}Ga_{0.6}N$ crystal obtained in Example 4 in an atmosphere of an oxygen concentration of 0.02% by mol by using 40% by mol of Al and 60% by mol of Ga as group III raw materials and an $NH_3$ gas as a nitrogen raw material by means of an HVPE method. On this occasion, an HCl gas was used as a carrier gas for each Al and Ga and 30% of an $H_2$ gas based on the $NH_3$ gas which is a nitrogen raw material gas was used. The $Al_{0.4}Ga_{0.6}N$ crystal obtained in the present Example showed an FWHM value of 82 arsec by XRD and a dislocation value of $8 \times 10^6$ $cm^{-2}$ by TEM observation.

As shown in Examples 1 to 6 in Tables I and II, the group III nitride crystal film and the metallic film were formed on the substrate, and then, after the resultant article was thermally treated, by forming an atmosphere of an oxygen concentration of 0.1% by mol or less when a group III nitride crystal for filling and a group III nitride crystal were grown, the group III nitride crystal having a dislocation density of less than $1 \times 10^9$ $cm^{-2}$ and good quality was obtained. Further, by forming an atmosphere of an oxygen concentration of 0.01% by mol or less, a group III nitride crystal having a dislocation density of $1 \times 10^8$ $cm^{-2}$ and good quality was obtained.

In contrast, since Comparative Example 1 forms the group III nitride crystal film and the metallic film but does not comprise the step of the thermal treatment, the dislocation density became as large as $8 \times 10^9$ $cm^{-2}$, and, in Comparative Example 2, since the oxygen concentration at the time of forming the group III nitride crystal for filling and a group III nitride crystal became over 0.1% by mol, the AIN crystal which is a group III nitride crystal was not obtained.

Further, as shown in Example 7, by growing a group III nitride crystal on the group III nitride crystal by the production method according to the present invention, the group III nitride crystal having a dislocation density of less than $1 \times 10^8$ $cm^{-2}$ and good quality was obtained.

It is to be understood that embodiments and examples disclosed herein are illustrative and not restrictive in all aspects. The scope of the invention should be determined with reference to the appended claims and not to the above descriptions and is intended to include meanings equivalent to such claims and all such modifications and variations as fall within the scope of such claims.

Industrial Applicability

As has been described above, according to the present invention, by forming a group III nitride crystal film and a metallic film on a substrate, and then, after the resultant article is thermally treated, forming an atmosphere of an oxygen concentration of 0.1% by mol or less when a group III nitride crystal for filling and a group III nitride crystal were grown, not only a GaN crystal, but also a group III nitride crystal having a small dislocation density and good quality and a production method therefor can be provided.

**Claims**

1.   A production method for a group III nitride crystal, being
     **characterized by** comprising the steps of:

     growing a group III nitride crystal film on a substrate;
     depositing a metallic film on the group III nitride crystal film;
     not only generating a pore in the metallic film but also forming a void portion in the group III nitride crystal film by thermally treating the substrate on which the group III nitride crystal film is grown and the metallic film is deposited;
     growing a group III nitride crystal for filling on the group III nitride crystal film in which the void portion is formed in an atmosphere of an oxygen concentration of 0.1% by mol or less to fill the void portion in the group III nitride crystal film; and
     growing a group III nitride crystal on the metallic film in an atmosphere of an oxygen concentration of 0.1% by mol or less.

2.   A production method for a group III nitride crystal, being **characterized by** comprising the steps of:

     growing a group III nitride crystal film on a substrate;
     depositing a metallic film on the group III nitride crystal film;
     not only changing the metallic film into a metallic nitride film and, further, generating a pore in the metallic film, but also forming a void portion in the group III nitride crystal film by thermally treating the substrate on which the group III nitride crystal film is grown and the metallic film is deposited;

growing a group III nitride crystal for filling on the group III nitride crystal film in which the void portion is formed in an atmosphere of an oxygen concentration of 0.1% by mol or less to fill the void portion in the group III nitride crystal film; and

growing a group III nitride crystal on the metallic nitride film in an atmosphere of an oxygen concentration of 0.1% by mol or less.

3. The production method for the group III nitride crystal as set forth in Claim 1 or 2, being **characterized by** forming the atmosphere of an oxygen concentration of 0.1% by mol or less at the time of growing the group III nitride crystal for filling and/or the group III nitride crystal, by at least one of a method of using an $H_2$ gas and a method of using carbon.

4. The production method for the group III nitride crystal as set forth in any one of Claims 1 to 3, wherein the group III nitride crystal is an $Al_xGa_yIn_{1-x-y}N$ crystal ($0 \leq x$, $0 \leq y$, $x+y \leq 1$).

5. The production method for the group III nitride crystal as set forth in any one of Claims 1 to 4, wherein the metallic film comprises titanium, vanadium or an alloy comprising at least one of titanium and vanadium.

6. The production method for the group III nitride crystal as set forth in any one of Claims 1 to 5, wherein thickness of the metallic film is from 10 nm to 1000 nm.

7. The production method for the group III nitride crystal as set forth in any one of Claims 1 to 6, being **characterized by** further removing the substrate to obtain only the group III nitride crystal grown on the metallic film of the substrate.

8. A production method for a group III nitride crystal, being
**characterized by** further comprising the step of growing a group III nitride crystal in an oxygen atmosphere of 0.1% by mol or less on the group III nitride crystal obtained by the method as set forth in any one of Claims 1 to 7.

9. A group III nitride crystal, being obtained by the method for obtaining the group III nitride crystal as set forth in any one of Claims 1 to 8.

FIG. 1A

FIG. 1B

FIG. 1C

FIG. 1D

FIG. 1E

<table>
<tr><td colspan="2">**INTERNATIONAL SEARCH REPORT**</td><td>International application No.<br>PCT/JP2004/007420</td></tr>
</table>

A. CLASSIFICATION OF SUBJECT MATTER
Int.Cl$^7$  H01L21/205

According to International Patent Classification (IPC) or to both national classification and IPC

B. FIELDS SEARCHED

Minimum documentation searched (classification system followed by classification symbols)
Int.Cl$^7$  C30B29/38, H01L21/205, 33/00, H01S5/323, 5/343

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2002-343728 A  (NEC Corp.),<br>29 November, 2002 (29.11.02),<br>Par. Nos. [0010] to [0062]; Figs. 1 to 8<br>& EP 1271627 A2<br>Par. Nos. [0042] to [0137]; Figs. 1 to 8<br>& US 2003/0017685 A1 | 1-9 |
| A | EP 1246233 A2  (NEC Corp.),<br>02 October, 2002 (02.10.02),<br>Par. Nos. [0049] to [0076]; Figs. 1 to 5<br>& JP 2003-178984 A<br>Par. Nos. [0059] to [0086]; Figs. 1 to 5<br>& US 2002/0197825 A1 | 1-9 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>17 August, 2004 (17.08.04) | Date of mailing of the international search report<br>31 August, 2004 (31.08.04) |
|---|---|
| Name and mailing address of the ISA/<br>Japanese Patent Office | Authorized officer |
| Facsimile No. | Telephone No. |

Form PCT/ISA/210 (second sheet) (January 2004)

**EP 1 523 033 A1**

| INTERNATIONAL SEARCH REPORT | International application No. |
|---|---|
| | PCT/JP2004/007420 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-44400 A  (Sumitomo Electric Industries, Ltd.),<br>15 February, 2000 (15.02.00),<br>Par. Nos. [0047] to [0071]; Figs. 1 to 6<br>& EP 967664 A1<br>Par. Nos. [0051] to [0072]; Figs. 1 to 6<br>& US 2002/0011599 A1 | 1-9 |

Form PCT/ISA/210 (continuation of second sheet) (January 2004)